# EUROPEAN PATENT SPECIFICATION

(11) **EP 1 533 548 B1**
(45) Date of publication and mention of the grant of the patent: **17.10.2012**
(21) Application number: 03791310.0
(22) Date of filing: 26.08.2003
(51) Int. Cl.: F16J 9/26, C23C 8/38

(54) **SIDE RAIL FOR COMBINATION OIL RING AND METHOD OF NITRIDING THE SAME**
SEITENLEISTE FÜR KOMBINATIONSÖLRING UND VERFAHREN ZU DEREN NITRIERUNG
RAIL LATERAL POUR ANNEAU D'HUILE DE COMBINAISON ET PROCEDE DE NITRATATION

(30) Priority: 27.08.2002 JP 2002246567
(43) Date of publication of application: 25.05.2005
(73) Proprietor: Riken Corporation, Tokyo 102-0073 (JP)
(72) Inventor: INOUE, Shigeo, Kashiwazaki-shi, Niigata 945-0027 (JP)
(74) Representative: Strobel, Wolfgang
(86) International application number: PCT/JP2003/010800
(87) International publication number: WO 2004/020878

(56) References cited:
- EP-A- 0 486 320
- GB-A- 2 153 488
- GB-A- 2 315 079
- JP-A- 6 325 946
- JP-A- 7 316 778
- JP-A- 58 005 456
- JP-A- 2002 030 394
- JP-A- 2003 287 130
- JP-A- 2003 313 649
- US-A- 5 176 760
- US-A- 5 308 089

## Description

### Technical Field

The present invention relates to the steel side-rails of a combined oil-control ring used for an internal combustion engine and a nitriding method of same. More particularly, the present invention relates to a microstructure of the nitriding layer, and a method for forming the microstructure.

A combined oil-control ring comprises a pair of side rails and a spacer expander for pushing the side rails in radial direction toward their outer peripheral sides and pressing them against an inner wall surface of a cylinder. A function of the oil-control ring is, therefore, to form an appropriate oil film on the inner wall of the cylinder and hence to lubricate piston rings and the cylinder. Another function is to scrape off excessive oil on the inner wall surface of the cylinder.

There are two sliding surfaces on the side rail having the construction mentioned above. One of the sliding surfaces is outer peripheral surface of the side rail, which is brought into sliding with the inner wall of the cylinder. The other sliding surface is inner peripheral surface of the side rail, which is brought into contact with ears of a spacer expander.

### Background Technique

Accordingly, Japanese Unexamined Utility-Model Publication (kokai) No. 53-147309 proposes to apply nitriding only on the inner and outer peripheral sliding surfaces of the side rails. Ion nitriding has been developed thereafter and applied to side rails. A feature of the ion nitriding is to enable formation of a thick nitriding layer only on the outer peripheral surface of the side rails. This feature is utilized in side rails developed in Japanese Unexamined Patent Publication (kokai) No. 5-44575. Specifically, nitriding on only the outer peripheral surface (i.e., no nitriding on side surfaces and inner peripheral surface) enhances the fracture resistance of the side rails and mitigates the aggressive property of the side rails against a ring groove of a piston. In these side rails hard chromium plating is applied on their inner surfaces. The side rails then developed have on both inner and outer peripheral surfaces nitride layers formed by ion nitriding (Japanese Unexamined Patent Publication (kokai) No. 5-332451). Furthermore, the side rails proposed in Japanese Unexamined Patent Publication (kokai) No. 7-4308 have on the outer and inner peripheral surfaces nitriding layers with numerically limited thickness.

Meanwhile, regarding the nitriding layer, Japanese Unexamined Patent Publication (kokai) No. 7-118826 discloses the conditions of special ion nitriding (radical nitriding) for forming a nitriding layer consisting of only diffusion layer free of a compound surface layer (so-called white layer or brittle layer). Japanese Unexamined Patent Publication (kokai) No. 7-316778 discloses an application of this nitriding layer to a piston ring. In these prior arts, however, hard grain-boundary phases (intergranular phases) in the nitriding layer have hardly been described.

Although pressing load of a spacer expander against the side rails is small, the pressing stress becomes considerably great because the contact area between the side rails and the spacer expander is small. Since the wear resistance of the nitriding layer itself should, therefore, be high, martensitic stainless steels having improved wear resistance, particularly SUS 440B equivalent materials, have been used for the nitriding base material.

When the ion nitriding is applied to the base material mentioned above, the compound surface layer is not formed, but a nitrogen diffusion layer and hard grain-boundary phases, referred to as the gull layer by the persons skilled in the art, are formed. Such microstructure incurs problems as wear of the inner surface of the cylinder, and roughening of the ring groove, and resulting in increased oil consumption.

The present inventors studied the wear of the steel materials with nitriding and discovered the following. The hard grain boundary phases mentioned above formed in the nitriding layer exert actually no influence upon the wear resistance of the nitrided material itself but considerably increases an aggressive property against an opposing material. The reason is elucidated to be that: relatively soft phases on the surface preferentially wear out; and, on the other hand, the wear of the hard grain boundary phases is so delayed that only these phases are brought into contact with the opposing material. This is comparable to a situation that surface of the opposing material is rubbed by a file.

JP 07316778 A discloses a nitrided layer constituted of a pure diffused layer which is formed on the whole surface of a base material and the nitrided layer should be completely free from the formation of brittle layers. A nitrided pistion ring made of steel is known from Japanese examing publication of utility model application 64-1956 etc. The known piston ring is surface hardened by nitriding. A diffused layer is formed around base material of a compression ring made of steel and an oil control ring made of steel. An oxide layer and a white layer are formed on the outermost surface of a piston ring. The oxide layer is very hard, brittle and porous. The white layer appears white under observation of an optical microscope. The oxide layer and white layer are referred to as compound layer or brittle layer, which incurs a number of problems when used without removal.

Accordingly, JP 07316778 A solves the above-indicated problems by plasma nitriding and provides a piston ring made of steel, which makes it unnecessary to remove the brittle layer after nitriding. Furthermore, since the surface of a piston ring is not heated by plasma, an embrittlement layer is not formed in the piston ring surface, but the layer which consists of a pure diffusion zone is formed. However, JP 07316778 A does not show that the hard grain boundary phase is not formed in the grain boundaries.

The present invention solves problems of the prior art that oil consumption is increased by the wear of the inner surface of the cylinder and roughening of the ring groove. The essence of the present invention resides in the microstructure of the nitriding layer, which is free of the compound surface layer and is also free of the hard grain boundary phase (ε phase) of high aggressive property on at least the sliding surface.

The present invention is related to side rails, which are combined with a spacer expander to construct an oil-control ring, and wherein nitriding layers are formed on outer peripheral surfaces or inner and outer peripheral surfaces of side rails made of steel, consists of nitrogen diffusion layers free of compound surface layer, and has surface hardness of Hv 1000 or more and hard grain boundaries phoses are absent in surface region of the nitrogen diffusion layer.)

The side rails are characterized in that said nitriding layers are free of hard grain boundary phases (ε phases) in the surface region of the nitrogen diffusion layers, said nitriding layers are obtainable by a radical nitriding under the conditions of 550 ~ 600°C of temperature, 0,5~5 Torr of pressure, 3/7 ~ 9/1 of flow rate ratio of NH₃/H₂, and -400 ~ -500V of voltage including pretreatment sputtering during temperature elevating up to the nitriding temperature, and in that the thickness of said surface region of the nitrogen diffusing layer is 1/3 or more of the thickness of said nitriding layer.

Furthermore, the present invention relates to a method for nitriding side rails comprising the steps of:
- shaping wire material for side rails into a coil form;
- aligning outer peripheral surfaces of the coil using an inner surface of a sleeve, squeezing the coil vertically using a pressing jig (21) to bring adjacent upper and lower side surfaces of the coil into close contact with one another in the sleeve, and taking the coil with the pressing jig (21) out of the sleeve, thereby setting the coil with the jig; and
- nitriding the coil set with the jig in a radical nitriding furnace in the conditions of 550 ~ 600°C of temperature, 0,5 ~ 5 Torr of pressure, 3/7 ~ 9/1 of flow rate ratio of NH₃/H₂, and -400 ~ -500V of voltage including pretreatment sputtering during temperature elevating up to the nitriding temperature.

The nitriding layer of side rails according to the present invention is free of the compound surface layer. There is, therefore, no need for removal of the compound surface layer after the nitriding.

In addition, the hard grain boundary phases may be formed in the inner region of the nitrogen diffusion layer according to the present invention because of the following reason. While Cr₂₈C₆, precipitates in the base material, are almost transformed into CrN by nitriding, C (carbon) is expelled and diffuses toward the grain boundary region; and, a compound of Fe, C and N, particularly, the ε phase (that is, "hard grain boundary phase") is formed in the grain boundary when the nitrogen concentration in the grain boundary exceeds a certain level. The reason why the expelled C diffuses toward the grain boundary is attributable to the extremely low solubility of C in the martensitic stainless steel.

The microstructure of nitriding layer according to the present invention is (a) no hard grain boundary phase is formed in the surface region of the nitrogen diffusion layer, and the hard grain boundary phases are formed in the inner region of the nitriding layer; or (b) the hard grain boundary phases are absent in the entire nitriding layer. Whether the microstructure (a) or (b) is formed depends on nitriding conditions, particularly, the thickness of the nitriding layer. The reason for the non-formation of the hard grain boundary phase is the very small C quantity in the grain boundaries.

There are variable factors for forming the nitriding layer mentioned above, such as setting method of the side rails (coil), temperature, pressure, flow-rate ratio of NH₈/H₂, voltage and nitriding time in the radical nitriding, which is one type of plasma nitriding. The nitriding layer having the features mentioned above can be formed by nitriding conditions such as the factors mentioned above.

There is actually no difference during the initial sliding period between the wear of side rails having the microstructure free of the hard grain boundary phase (A) and that of side rails having the microstructure with the hard grain boundary phases (B). When sliding advances to a certain extent, wear within the crystal grains occurs in the side rails (B), with the result that the convex hard grain boundary phases remain on the surface of the side rails and shave the opposing material. When the sliding proceeds further, the opposing material may be worn out the convex hard grain boundary phases, and the initial sliding conditions may then be realized. However, such wear progress is a rare case. The opposing material is greatly worn out, because the hard grain boundary phases protrude from and are firmly held by the adjacent crystal grains. Contrary to this, in the side rails (A), hard grain boundary phases are absent in the microstructure of a surface region of the nitrogen diffusion layer, that is, the sliding surface. The aggressive property described above, therefore, does not generate. Spherical precipitates within the grains mitigate the wear of grains by the opposing material. The grain-boundaries are more liable to be worn out than the crystal grains. But preferential wear of the grain boundaries by the opposing material does not occur.

### Brief Description of Drawings

Figure 1 shows an embodiment of a combined oil-control ring, an element of which is the side rails.
Figure 2 is an Fe-N-C ternary diagram at 580°C.
Figure 3 shows a schematic of gas nitriding apparatus.
Figure 4 shows a schematic of ion nitriding apparatus.
Figure 5 shows a schematic of radical nitriding apparatus.
Figure 6 shows a coil (side rails) set with jig for nitriding only the outer peripheral surface of the side rails.
Figure 7 shows a coil (side rails) set with jig for nitriding the inner and outer peripheral surfaces of the side rails.
Figure 8 shows the cross-sectional microstructure of a side rail having the nitriding layer only on the outer peripheral surface.
Figure 9 shows the cross-sectional microstructure of a side rail having the nitriding layers only on the inner and outer peripheral surfaces.
Figure 10 is an enlarged view of the cross-sectional microstructure of nitriding layer according to the present invention.
Figure 11 is an enlarged view of the cross-sectional microstructure of the nitriding layer by gas nitriding according to Comparative Example 1
Figure 12 is an enlarged view of the cross-sectional microstructure of the nitriding layer by ion nitriding according to Comparative Example 2

### Description of Embodiments of Invention

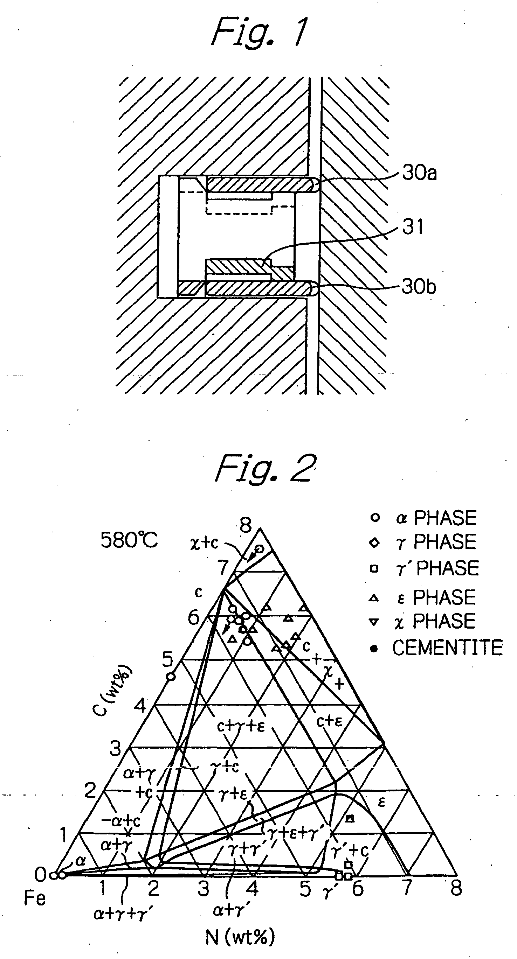

Referring to Fig. 1, a combined oil-control ring is shown. This ring is made of steel and is mounted in an oil-ring groove of a piston inserted in a cylinder. The combined oil-control ring consists of a pair of the annular, upper and lower side rails 30a, b having a gap, and an annular spacer expander 31 having a gap.

The spacer expander has a meander form in the axial direction. It has outer plateau portions for holding and separating the side rails and inner ear portions for exerting pressure on the side rails 30a,b.

The fundamental theory to avoid the formation of the ε phase in the grain boundary is explained hereinafter. The nitriding layer is formed by reaction of active species on the surface of the base material and subsequent diffusion of the nitrogen. The reaction speed is not generally equal to the diffusion speed. Thickness of the nitriding layer is determined by diffusion. Meanwhile, the microstructure and the phase morphology of the nitriding layer itself are greatly dependent upon the reaction speed of the active species.

For example, when the nitriding layer formed on the surface comprises a compound surface layer, the reaction speed of an active species is greater than its diffusion speed, and the nitrogen concentration in the vicinity of the surface gradually increases. When this nitrogen concentration exceeds approximately 5.8 % by weight at 580°C, the phase transformation of r'+ ε occurs as shown in Fig. 2. These phases, which have certain thickness, are referred to as the compound surface layer.

On the other hand, when the reaction speed is less than or equal to the diffusion speed, nitrogen does not concentrate in the vicinity of the surface. The phase transformation to γ' phase and ε phase, therefore, does not occur but only the diffusion layer is formed. Any nitriding not to form the compound surface layer is carried out under the concept described above.

As described hereinabove, the grain boundary ε phases may or may not be formed depending upon the difference between the nitrogen quantity reacted and diffused in the grain boundaries and the nitrogen quantity diffused from the grain boundaries. Particularly, since C, which is expelled from the carbide due to nitriding, is present in the grain boundaries, the nitrogen concentration required for forming the ε phase greatly shifts to a lower level. As is depicted in Fig. 2, the phase diagram shows that when approximately 0.5 % by weight of C is dissolved in Fe, then, the nitrogen concentration required for forming the ε phase is decreased to approximately to 2% by weight.

The nitriding conditions required for not forming the ε phase in the grain boundaries are, therefore, as follows.
(1) High nitriding temperature to accelerate diffusion in the grain boundary portions.
(2) Low nitrogen potential to decrease the nitrogen quantity reacted with the surface of the base material.
(3) Low voltage to decrease the nitrogen quantity reacted with the surface of the base material under an electric field, such as plasma nitriding.
(4) Sputtering is carried out to discharge from the surface C, which is expelled by nitriding and is present in the grain boundaries in order to increase the nitrogen concentration required for forming the ε phase.

A nitriding apparatus and the nitriding conditions, which satisfy the conditions mentioned above, should be controlled not to form the hard grain boundary phases.

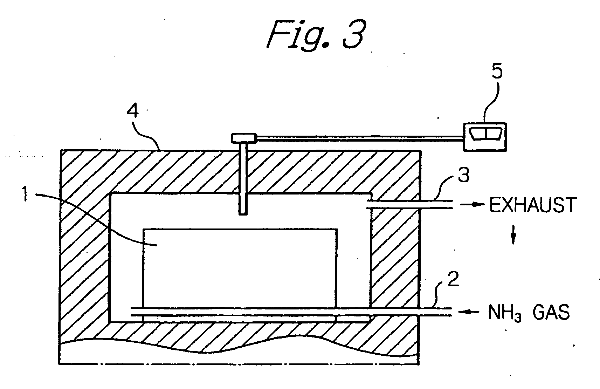

What kind of nitriding method can satisfy conditions (1) ~ (4) ? The radical nitriding apparatus is the most appropriate. Evidently, the nitriding layer free of the hard grain boundary phase (ε phase) can be formed by means of the gas nitriding and the ion nitriding, provided that the nitriding conditions are appropriate. The gas nitriding, the ion nitriding and the radical nitriding methods are illustrated in Figs. 3, 4 and 5, respectively. In addition, the respective nitriding methods are shown in Table 1 for comparison.

**Table 1: Comparison of Nitriding Methods**

| | Gas Nitriding | Ion Nitriding | Radical Nitriding |
|---|---|---|---|
| Supplying Gases | NH₃/N₂ | N₂/H₂ | NH₃/H₂ |
| Heat Source | External Heater | Heating by Sputtering | External Heater (90%) + Sputtering (10%) |
| Voltage (V) | 0 | 560 - 700 | 400 - 500 |
| Pressure (Torr) | 760 | 1 - 5 | 0.5 - 5 |
| Temperature (°C) | 500 - 590 | 500 - 590 | 500 - 590 |
| Heat Generation | No | Large | Small |
| Nitriding Reactive Species | NH Radicals | N Ions | NH Radicals |
| Reaction | CVD | PVD | Mainly CVD |

First, in the gas nitriding shown in Fig. 3, materials to be treated are arranged in a work-piece chamber 1 located in a nitriding furnace. NH₃ gas and carrier gas are ejected through the gas conduit 2 into the work-piece chamber 1 and then ejected through an appropriate outlet (not shown) into the furnace. The gases are discharged through the conduit 3 out of the furnace and are made to safety by a waste gas apparatus. The materials to be treated are heated by an external heater 44. In order to control temperature in the furnace interior, a temperature controller 5 is used. In such gas nitriding method, it is possible to elevate the temperature according to condition (1) mentioned above, and to decrease the NH₃ concentration according to condition (2), which stipulates adjustment of the nitriding potential. However, since the gas nitriding method has no function to discharge C from the surface according to condition (4) mentioned above, formation of hard grain boundary phases cannot be suppressed unless the NH₃ concentration is decreased to considerably low levels. However, when the NH₃ concentration is decreased to such low level, the nitriding time has to be prolonged and often results in non-uniformity in nitriding depth. It is, therefore, impractical to obtain by the gas nitriding method a nitriding layer free of the hard grain boundary phase.

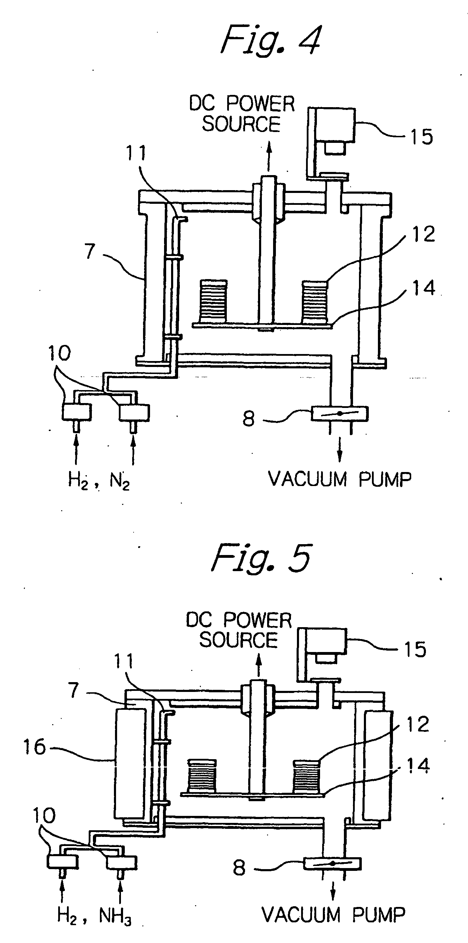

Second, in the ion nitriding method shown in Fig. 4, the interior of a chamber 7 is evacuated by a vacuum pump (not shown). An automatic pressure controller 8 controls pressure in the chamber 7. Reacting gases evacuated are made to safety by the waste gas apparatus. The raw material gases, H₂ and N₂, are ejected via the respective mass-flow controllers 10 and a nozzle 11 into the chamber 7. Meanwhile, since the work pieces 12 (materials to be treated) are placed on the electrode 14 which is in electrical contact with the direct current source (not shown), a sheath region, which is a voltage drop region, is formed on the surface of the work pieces, and gases are ionized in the sheath region. Ionized gases are then reacted with the surface of the work pieces. A pyroscope for observing the furnace interior is denoted by the reference numeral 15.

Since no external heater is provided in such nitriding method, the nitriding temperature of work pieces is attained only by means of raising the voltage. In other words, the nitriding temperature is attained only by the sputtering effect. Since the voltage is high, the conditions (4) and (1) are attained. That is, the sputtering discharges out from the surface C present in the grain boundaries. The temperature is so high that the diffusion speed increases. However, since the voltage is high, the reacting nitrogen quantity is increased contrary to condition (3). It is, therefore, extremely difficult to suppress the formation of the ε phase in the grain boundaries.

The radical nitriding method shown in Fig. 5 has actually the same construction as the ion nitriding apparatus and is additionally provided with an external heater 16 in contrast to the ion nitriding methods described above. The radical nitriding method is provided with an external heater 16 and uses the NH₃ gas, which is highly active, as the raw material gas, and can therefore advantageously determine the temperature and voltage independently of one another. Specifically, the temperature is elevated and maintained mainly by the external heater 16. Thus the diffusion speed of nitrogen in the work pieces can be increased. On the other hand, the voltage can be as low as possible. The main purpose for this is to discharge C, which is present in the grain boundaries in the vicinity of the surface of the work pieces. The voltage can be as low as possible to activate NH₃ and hence to suppress the reaction speed of the nitrogen sources. The nitriding conditions, described above can satisfy all of the four conditions for suppressing the formation of the hard grain boundary phases. That is, there is no major difficulty in the radical nitriding method for not forming the hard grain boundary phases.

The radical nitriding was carried out in the examples of the present invention for the reasons described hereinabove.

The base material of side rails according to the present invention may be basically any grade of steel for nitriding. The nitriding layer free of the hard grain boundary phase as intended in the present invention can be formed on such steels for nitriding. All of the steels for nitriding are, therefore, included in the present invention. Desirably, the one having good sliding property is, however, used for the side rails. Among the steels for nitriding, martensitic stainless steel, particularly SUS 440B series steel for nitriding, in which CrN precipitates are formed after nitriding, is the most desirable.

Details of the method for nitriding side rails are hereinafter described.

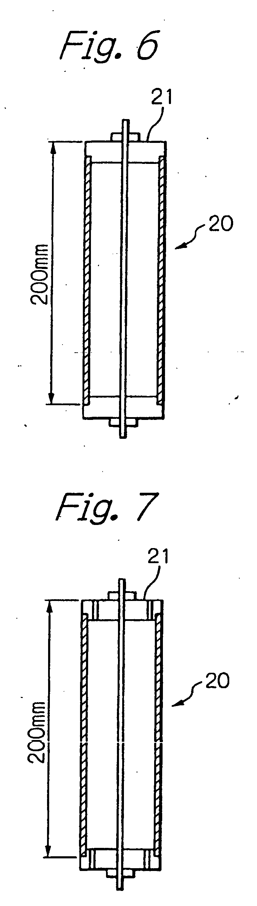

According to a setting method of side rails, the rails 20 shaped into a coil form are squeezed vertically by means of a pressing jig 21 in such a manner that adjacent upper and lower surfaces of the rails are brought into close contact with one another as shown in Fig. 6. When the only outer peripheral surface is to be nitrided, the pressing jig should have a cap form so as not to nitride the inner peripheral surface of rails. When the pressing jig 21 is in the form of a cap, a closed space is formed by the pressing jig and the inner peripheral surface of rails. An electric field is not formed on the inner peripheral surface of the rails and the pressing jig according to the Gauss law. Glow discharge, therefore, does not occur on these surfaces, which are therefore not nitrided.

On the other hand, when the inner and outer peripheral surfaces are to be nitrided, an open space is formed close to the inner peripheral surface of the rails. The apertures 22 must therefore be opened through the pressing jig 21 so as to connect the open space with the exterior space as shown in Fig. 7. Since the size of the apertures 22 determines the electric field, the thickness of the nitriding layer on the inner peripheral surface of side rails can be adjusted by controlling the size of the apertures 22.

Next, with regard to preferable nitriding conditions, sputtering is carried out during temperature elevating stage up to the nitriding temperature. A purpose of the sputtering is to utilize it for eliminating the oxide film and the passive film present on the surface and heating the side rails. The atmosphere gas at the sputtering is preferably H₂ or Ar.

Further, the nitriding temperature set by the external heater is preferably 550°C or more and 600°C or less. Below 550°C, the diffusion speed of nitrogen is too slow to avoid formation of hard grain boundary phases. Above 600°C, the base material is annealed and softened, with the result the nitriding layer also softens. The wear resistance is thus lowered. Appropriate temperature is in a range of from 570°C to 590°C.

Gas pressure set by the automatic pressure controller 8 is preferably from 0.5 to 5 Torr. Below 0.5 Torr, the NH₃ potential is too low for the nitriding to proceed. Above 5 Torr, the reacting nitrogen quantity is too large to avoid the formation of hard grain boundary phases. Optimum gas pressure is in a range of from 1 to 3 Torr.

The NH₃/H₂ ratio, which is set by a mass-flow controller 10, is preferably in a range of from 3/7 to 9/1 in terms of the flow-rate ratio. Below 3/7 of the NH₃/H₂ ratio, the nitriding speed is too slow and is impractical. Above 9/1 of the NH₃/H₂ ratio, the NH₃/H₂ potential is too high to avoid formation of hard grain boundary phases. Optimum NH₃/H₂ ratio is from 7/3 to vicinity of 8/2.

The voltage is in a range of from -400V to -550V. Above -400V (below 400V in the absolute value), the NH radicals formed are too few to contribute to the nitriding. In addition, since sputtering is not effective to discharge C, it is difficult to avoid the formation of hard grain boundary phases. Below -550V (above 550V in the absolute value), the voltage and hence the reaction speed of radicals are so high that it is difficult to avoid the formation of hard grain boundary phases. Optimum voltage is in a range of from -475V to -525V. The voltage is selected within this range to attain optimum reacting nitrogen quantity and discharging C quantity by sputtering.

The present invention is hereinafter explained in detail with reference to the examples.

### Best Mode for Carrying Out Invention

The chemical composition of the base material used in the present invention is shown in Table 2.

**Table 2**

| Chemical Composition (Weight %) of Base Material of Side Rails Used in Present Invention | | | | | | | | |
|---|---|---|---|---|---|---|---|---|
| Element | C | Si | Mn | P | S | Cr | Mo | V |
| Analysis Value | 0.86 | 0.38 | 0.32 | 0.030 | 0.001 | 17.28 | 1.09 | 0.10 |

A wire used for the side rails had a cross-sectional size of 0.4 × 2.02 mm and the chemical composition shown in Table 2. This wire was shaped into a coil form. The shaped coil had 76mm of outer diameter and 340mm of length. This coil was located in a sleeve in such a manner that no clearance is formed between the outer periferal surfaces of the coil and the inner surface of the sleeve. The coil is then squeezed vertically by means of the pressing jig 21 as shown in Figs. 6 and 7. The coil set with jig shown in Fig. 6 is used for producing the side rails with nitriding only on the outer peripheral surfaces. The coil set with jig shown in Fig. 7 is used for producing the side rails with nitriding only the inner and outer peripheral surfaces.

The coil set with jig described above is located in a radical nitriding furnace. Pretreatment sputtering was carried out during the temperature elevating. The radical nitriding was subsequently carried out. The conditions are as follows:
(1) Pretreatment Conditions (during the temperature elevating)
   Pressure: 0.8 Torr
   Gas: H₂
   Voltage: - 500V
   Temperature: 540°C or more and up to 580°C
   Temperature Elevating Speed: 1°C/minute
(2) Nitriding Conditions
   Temperature: 580°C
   Pressure: 2 Torr
   Gas: NH₃, H₂
   Flow Rate of NH₃/H₂: 7/3
   Voltage: - 500V
   Nitriding Time: 3 hours

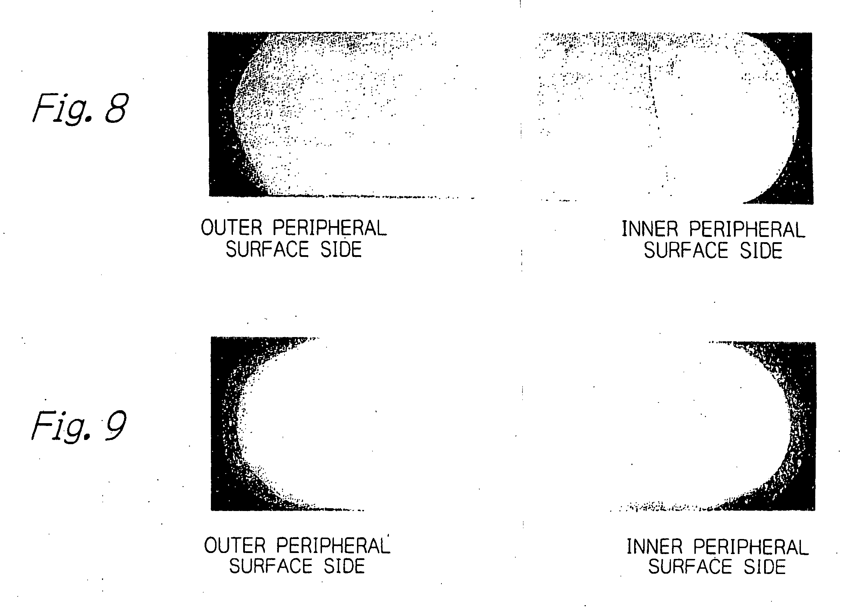

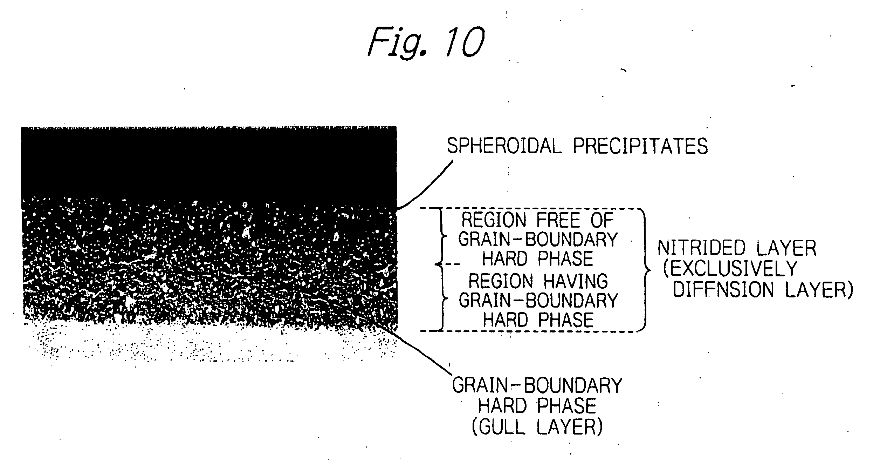

The nitriding results are shown in Figs. 8 and 9. A side rail with nitriding on only the outer peripheral surface is shown in Fig. 8. A side rail with nitriding on only the inner and outer peripheral surfaces is shown in Fig. 9. Since the microstructure of the nitriding layer of both side rails are identical, an enlarged microstructure of the only one nitriding layer shown in Fig. 8 is shown in Fig. 10. As is apparent from Fig. 10, the compound surface layer is absent; only spheroidal precipitates are observed in the surface region of the nitrogen diffusion layer, which thickness of the region is of 1/3 or more of thickness of the nitriding layer, and the hard grain boundary phases (ε phase) are absent.

As shown in Fig. 8, the nitriding layer is present only on the outer peripheral surface of the coil set by the method shown in Fig. 6. The nitriding layer is present on the inner and outer peripheral surfaces of the coil set by the method of Fig. 7. The compound surface layer is absent in the nitriding layer of both examples. In addition, the hard grain boundary phases are absent in the surface region of the nitrogen diffusion layer, which the thickness of the region is of 1/3 or more of the thickness of the nitriding layer.

### Comparative Example 1

Coil (side rails) set by the method shown in Fig. 7 are nitrided by gas nitriding. The conditions of gas nitriding are as follows:
Temperature: 575°C
Gas: NH₃ (90%) - dry air (10%)
Pressure: 1 atm
Nitriding Time: 6 hours

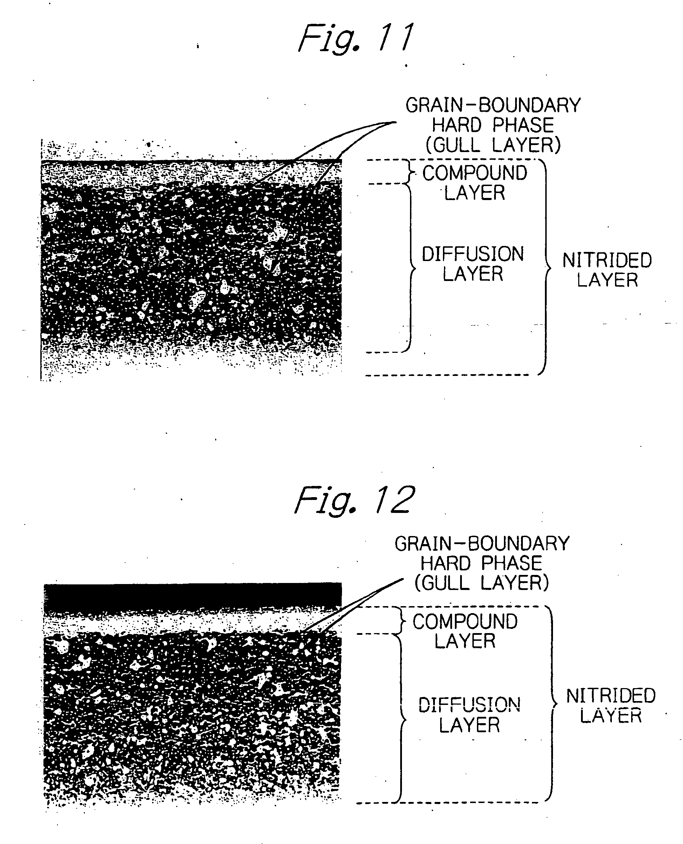

The microstructure of the resultant nitriding layer is shown in Fig. 11. The compound surface layer and the hard grain boundary phases are observed in the sliding surface side of the nitriding layer. This is outside the scope of the present invention.

### Comparative Example 2

Coil (side rails) set by the method shown in Fig. 7 are nitrided by ion nitriding. The conditions of ion nitriding are as follows:
Temperature: 550°C
Gas: N₂/H₂ = 7/3 (flow-rate ratio)
Voltage: 600V
Pressure: 4 Torr
Nitriding Time: 20 hours

The microstructure of the resultant nitriding layer is shown in Fig. 12. The compound surface layer and the hard grain boundary phases are observed in the sliding surface side of the nitriding layer. This is outside the scope of the present invention, too.

### Comparative Examples 3~10

The coil (side rails) set by the method shown in Fig. 7 are subjected to the radical nitriding under various conditions (Table 3). The results (depth of nitriding layer, presence or absence of compound surface layer, presence or absence of hard grain boundary phases in the sliding surface side of the nitriding layer, and hardness at a depth of 20 µm from the surface of nitriding layer) are shown in Table 4.

In Comparative Example 3, since the nitriding temperature was low, non-uniformity in nitriding thickness, the compound surface layer and the hard grain boundary phases were observed.

In Comparative Example 4, since the nitriding temperature was high, the hardness of the nitriding layer was as low as HV850.

In Comparative Example 5 (low pressure), Comparative Example 7(low flow-rate ratio of NH₃ gas), and Comparative Example 9 (low voltage) non-uniformity in nitriding thickness resulted. In Comparative Example 6 (high pressure), Comparative Example 8 (high flow-rate ratio of NH₃ gas), and Comparative Example 10 (high voltage), the compound surface layer and hard grain boundary phases were observed.

As is described hereinabove, all production methods, which lie outside the scope of the present invention, could not provide a solution to the problems of the prior arts.

**Table 3 Nitriding Conditions of Present Invention And Comparative Examples 3 - 10**

| | Temperature (°C) | Pressure (Torr) | NH₃/H₂ (Flow Rate Ratio) | Voltage | Nitriding Time (minutes) |
|---|---|---|---|---|---|
| Invention | 580 | 2 | 7/3 | 500 | 180 |
| Comparative Example-3 | 545 | 2 | 7/3 | 500 | 180 |
| Comparative Example-4 | 605 | 2 | 7/3 | 500 | 180 |
| Comparative Example-5 | 580 | 0.4 | 7/3 | 500 | 180 |
| Comparative Example-6 | 580 | 5.1 | 7/3 | 500 | 180 |
| Comparative Example-7 | 580 | 2 | 2.9/7.1 | 500 | 180 |
| Comparative Example-8 | 580 | 2 | 9.1/0.9 | 500 | 180 |
| Comparative Example-9 | 580 | 2 | 7/3 | 390 | 180 |
| Comparative Example-10 | 580 | 2 | 7/3 | 560 | 180 |

**Table 4 Nitriding Results of Present Invention and Comparative Examples 3 through 10**

| | Thickness of Nitride Layer (µm) | Compound Surface Layer | Hard Grain Boundary Phases | Hardness (Hv) |
|---|---|---|---|---|
| Invention | 57 | Absent | Absent | 1100 |
| Comparative Example-3 | Non-Uniformity | Present | Present | 1205 |
| Comparative Example-4 | 69 | Absent | Absent | 850 |
| Comparative Example-5 | Non-Uniformity | Absent | Absent | Measurement Impossible |
| Comparative Example-6 | 65 | Present | Present | 1153 |
| Comparative Example-7 | Non-Uniformity | Absent | Absent | Measurement Impossible |
| Comparative Example-8 | 64 | Present | Present | 1025 |
| Comparative Example-9 | Non-Uniformity | Absent | Absent | Measurement Impossible |
| Comparative Example-10 | 62 | Present | Present | 1020 |

Subsequently, the aggressive property against the opposing material was evaluated. For this purpose, the front end of pin material was nitrided under the conditions of inventive Example and Comparative Example 1. The compound surface layer of the gas nitrided Comparative Example 1 was removed. Then, the wear test was carried out. The hard grain boundary phases were absent on the sliding surface of the inventive Example. In Comparative Example 1, the hard grain boundary phases were present on the sliding surface, from which the compound surface layer was removed.

The wear test was carried out by a pin-on-drum type test under the following conditions.
Drum Material (Opposing Material): FC250
Frictional Sliding Speed: 0.25m/second
Testing Load: 39.2N
Testing Time: 6 hours
Lubricating Conditions: dropping of sulfuric-acid aqueous solution (PH = 2), at 0.1ce/second

The test results are as shown in Table 5.

**Table 5**

| | Wear Amount of Pin (µm) | Wear Amount of Drum (µm) |
|---|---|---|
| Inventive Example | 2.6 | 1.2 |
| Comparative Example 1 | 2.7 | 2.6 |

As shown in Fig. 5, the pin wear of the Inventive Example is at the same level as that of the Comparative Example 1. The wear of drum material according to the present invention is 1/2 or less than that according to the Comparative Example 1. It is shown that the Inventive Example significantly decreases the wear amount of the opposing material. The aggressive property against the opposing material is, therefore, greatly mitigated.

### Industrial Applicability

The nitriding layer of side rails according to the present invention has lessened aggressive property against the opposing material. Wear resistant properties of the liner and the ring groove are, therefore, outstandingly improved. Accordingly, it is possible to provide side rails used for a combined oil-control ring, which can maintain the oil-controlling performance for a long period of time.

## Claims

1. Side rails (30a, 30b) used for a combined oil-control ring, which are combined with a spacer expander (31), wherein nitriding layers are formed on outer peripheral surfaces or inner and outer peripheral surfaces of the side rails (30a, 30b) made of steel, consisting of nitrogen diffusion layers free of compound surface layer, and having surface hardness of Hv 1000 or more,
**characterized in that**
said nitriding layers are free of hard grain boundary phases (∈ phases) in the surface region of the nitrogen diffusion layers, said nitriding layers are obtainable by a radical nitriding under the conditions of 550 ~ 600°C of temperature, 0,5 ~ 5 Torr of pressure, 3/7 ~ 9/1 of flow rate ratio of NH₃/H₂, and -400 - -500V of voltage including pretreatment sputtering during temperature elevating up to the nitriding temperature,
and **in that** the thickness of said surface region of the nitrogen diffusing layer is 1/3 or more of the thickness of said nitriding layer.

2. A method for nitriding side rails (20) comprising the steps of:
shaping wire material for side rails into a coil form;
aligning outer peripheral surfaces of the coil using an inner surface of a sleeve, squeezing the coil vertically using a pressing jig (21) to bring adjacent upper and lower side surfaces of the coil into close contact with one another in the sleeve, and taking the coil with the pressing jig (21) out of the sleeve, thereby setting the coil with the jig; and
nitriding the coil set with the jig in a radical nitriding furnace in the conditions of 550 ~ 600°C of temperature, 0,5 ~ 5 Torr of pressure, 3/7 ~ 9/1 of flow rate ratio of NH₃/H₂, and -400 ~ 500V of voltage including pretreatment sputtering during temperature elevating up to the nitriding temperature.

## Patentansprüche

1. Seitenleisten (30a, 30b) zur Verwendung für einen kombinierten Öl-Steuerungsring, die kombiniert sind mit einem Abstands-Breithalter (31), wobei die Nitrierschichten an den äußeren Umfangsoberflächen oder den inneren und äußeren Umfangsflächen der Seitenleisten (30a, 30b), die aus Stahl sind, ausgebildet sind, wobei sie aus Stickstoffdiffusionsschichten bestehen, frei von einer Verbundoberflächenschicht, und mit einer Oberflächenhärte von HV 1000 oder mehr,
**dadurch gekennzeichnet,**
**dass** die Nitrierschichten frei von harten Korngrenzenphasen (ε-Phasen) im Oberflächenbereich der Stickstoffdiffusionsschichten sind, wobei die Nitrierschichten durch Radikalnitrieren unter den Bedingungen von 550 - 600°C Temperatur, 0,5 - 5 Torr Druck, 3/7 - 9/1 des Flussratenverhältnisses von NH₃/H₂, und -400 - -500 V erhaltbar sind, einschließlich Vorbehandlungssputtern während des Temperaturanstiegs bis zur Nitriertemperatur,
und **dass** die Dicke des Oberflächenbereichs der Stickstoffdiffusionsschicht 1/3 oder mehr der Dicke der Nitrierschicht beträgt.

2. Verfahren zum Nitrieren von Seitenleisten (20), das folgende Schritte aufweist:
Formen von Drahtmaterial für Seitenleisten in einem Spufenrahmen;
Ausrichten der äußeren Umfangsoberflächen der Spule unter Verwendung einer inneren Oberfläche einer Hülse, Drücken der Spule vertikal unter Verwendung einer Anpressvorrichtung (21), um die benachbarten oberen und unteren Seitenoberflächen der Spule in engen Kontakt miteinander in der Hülse zu bringen und Herausnehmen der Spule mit der Anpressvorrichtung (21) aus der Hülse heraus, wodurch die Spule mit der Anpressvorrichtung gesetzt wird;
Nitrieren der Spule, die mit der Anpressvorrichtung gesetzt ist in einem Radikalnitrierofen unter den Bedingungen von 550 - 600°C, 0,5 -5 Torr Druck, 3/7 - 9/1 des Flussratenverhältnisses von NH₃/H₂, und -400 - -500 V von Spannung einschließlich Vorbehandlungssputtern während des Temperaturanhebens bis zur Nitriertemperatur.

## Revendications

1. Rails latéraux (30a, 30b) utilisés pour un segment racleur d'huile combiné, qui sont combinés avec un organe expansible d'espacement (31), dans lesquels des couches de nitruration sont formées sur des surfaces périphériques extérieures ou des surfaces périphériques intérieure et extérieure des rails latéraux (30a, 30b) en acier, constitués de couches de diffusion d'azote exemptes de couche de surface composite, et ayant une dureté superficielle de 1 000 Hv ou plus,
**caractérisés en ce que**
lesdites couches de nitruration sont exemptes de phases dures aux joints de grains (phase ε) dans la région de surface des couches de diffusion d'azote, lesdites couches de nitruration peuvent être obtenues par une nitruration radicalaire sous les conditions de 550 à 600°C de température, 0,5 à 5 Torr de pression, 3/7 à 9/1 de rapport de débit de NH_{3/}H₂, et de - 400 à - 500 V de tension incluant une pulvérisation cathodique de prétraitement pendant une élévation de température jusqu'à la température de nitruration,
et **en ce que** l'épaisseur de ladite région de surface de la couche de diffusion d'azote est de 1/3 ou plus de l'épaisseur de ladite couche de nitruration.

2. Procédé pour nitrurer des rails latéraux (20) comprenant les étapes de :
mise en forme d'un matériau en fil pour rails latéraux en une forme de bobine ;
alignement des surfaces périphériques extérieures de la bobine en utilisant une surface intérieure d'une gaine, la compression verticale de la bobine en utilisant un montage de pression (21) pour amener des surfaces latérales supérieure et inférieure adjacentes de la bobine en contact étroit l'une avec l'autre dans la gaine, et l'extraction de la bobine avec le montage de pression (21) hors de la gaine, en fixant ainsi la bobine avec le montage ; et
nitruration de la bobine fixée avec le montage dans un four de nitruration radicalaire dans les conditions de 550 à 600 °C de température, 0,5 à 5 Torr de pression, 3/7 à 9/1 de rapport de débit de NH₃/H₂ et de - 400 à - 500 V de tension incluant une pulvérisation cathodique de prétraitement pendant une élévation de température jusqu'à la température de nitruration.
